# FASCICULE DE BREVET EUROPEEN

(11) **EP 0 598 654 B1**
(45) Date de publication et mention de la délivrance du brevet: **03.01.1996**
(21) Numéro de dépôt: 93402767.3
(22) Date de dépôt: 15.11.1993
(51) Int. Cl.: G11C 17/18

(54) **Procédé et circuit de claquage de fusible dans un circuit intégré**
Verfahren und Schaltung zum Durchbrennen von Sicherung in einen integrierten Schaltkreis
Procedure and circuit for fuse blowing in an integrated circuit

(30) Priorité: 18.11.1992 FR 9213831
(43) Date de publication de la demande: 25.05.1994
(73) Titulaire: GEMPLUS CARD INTERNATIONAL, F-13420 Gemenos (FR)
(72) Inventeur: Kowalski, Jacek, F-94230 Cachan (FR)
(74) Mandataire: Schmit, Christian Norbert Marie

(56) Documents cités:
- EP-A- 0 232 565
- EP-A- 0 432 049
- EP-A- 0 432 050
- WO-A-92/16947
- FR-A- 2 608 826
- US-A- 4 122 547
- IEEE TRANSACTIONS ON ELECTRON DEVICES vol. ED-32 , Février 1985 , NEW YORK US pages 502 - 507 ATSUMI ET AL 'Fast Programmable 256K Read Only Memory with On-Chip Test Circuits'

## Description

L'invention se rapporte aux circuits intégrés, et plus spécialement ceux dans lesquels sont prévus des fusibles permettant de créer des connexions après la fabrication du circuit intégré.

A titre d'exemple, pour faire comprendre ce que sont ces fusibles, on rappelle qu'il est maintenant courant de prévoir, dans des circuits intégrés destinés à des cartes à puces, des zones de mémoire non volatile dont l'accès doit être interdit à l'utilisateur. Ces mémoires sont donc remplies avec des informations, après quoi un fusible est claqué pour isoler la zone de mémoire interdite, afin que son contenu ne puisse pas être transmis sur les bornes extérieures de la carte, ou afin que la mémoire ne puisse plus être écrite à partir de ces bornes. Une autre application des fusibles est la réalisation de mémoires mortes, ou de réseaux logiques programmables.

Les fusibles qui sont concernés ici sont les fusibles claquables électriquement. Ils ont l'avantage de permettre la modification du circuit intégré après encapsulation complète du circuit, et même après encartage dans une carte à puce. Un circuit de claquage est donc associé au fusible pour pouvoir claquer le fusible à partir d'un ordre transmis depuis l'extérieur du circuit intégré.

Sous l'appellation fusible on peut comprendre à la fois des éléments qui sont conducteurs dans l'état intact et qui passent en circuit ouvert dans l'état claqué, ou inversement des fusibles (parfois appelés anti-fusibles) qui sont isolants dans l'état intact et qui deviennent conducteurs dans l'état claqué. Ces derniers sont plus particulièrement, bien que non exclusivement, concernés par la présente invention.

Dans la demande de brevet EP-A-0 408 419, on a décrit par exemple un fusible ouvert dans l'état intact, réalisé à partir d'un conducteur en silicium polycristallin placé au dessus d'un conducteur en silicium monocristallin dopé, les deux conducteurs étant séparés par une couche isolante localement très mince (de l'ordre de 100 angströms d'épaisseur). La couche isolante très mince est suffisante pour assurer l'isolation entre les conducteurs sous les tensions normalement appliquées au circuit intégré. Elle peut toutefois être claquée par application d'une tension d'une vingtaine de volts, cette tension engendrant en effet à travers l'oxyde un champ électrique de plusieurs millions ou dizaines de millions de volts par centimètre, supérieur au seuil de claquage du matériau isolant. Une résistance de faible valeur est alors établie entre les conducteurs. Le fusible passe dans son état final, claqué. Un circuit à transistors permet de détecter les fuites de courant à travers la connexion de faible résistance, et permet d'interdire alors certaines fonctionnalités du circuit intégré (par exemple l'écriture ou la lecture de certaines zones de mémoire). Dans une application à un réseau programmable électriquement, le claquage des fusibles établit les connexions nécessaires pour obtenir les fonctions logiques souhaitées.

Un problème important des fusibles est la fiabilité du fusible dans l'état claqué : d'une part il faut créer des conditions de claquage qui aboutissent de manière certaine au claquage, et pas seulement de manière probable. D'autre part il faut être sûr qu'un fusible claqué ne peut pas revenir dans certaines conditions à son état intact (résistance de connexion quasi infinie) ou à un état incertain (résistance de connexion trop élevée).

La tension de claquage Vpp d'une vingtaine de volts peut être appliquée à partir de l'extérieur du circuit intégré, lorsque le fusible doit être claqué. Toutefois, pour des raisons de réduction du nombre de bornes de connexions et pour des raisons de simplification pour l'utilisateur, on préfère prévoir que la tension de claquage Vpp soit générée à l'intérieur même du circuit intégré, à partir de la tension Vcc plus faible (5 volts en général, mais moins dans le futur) qui sert au fonctionnement normal du circuit. Cette tension de claquage Vpp est par ailleurs nécessaire dans les circuits à mémoire non volatile (EEPROM), et il est donc raisonnable de vouloir se servir de la même tension pour claquer électriquement les fusibles.

L'expérience a cependant montré que la fiabilité du claquage des fusibles n'était pas toujours très bonne, et ceci tout spécialement lorsque la tension de claquage était produite à partir de l'intérieur d'un circuit intégré alimenté par une tension Vcc plus faible que la tension de claquage nécessaire.

Une des raisons qu'on a trouvé à ce défaut semble être le fait que la tension Vpp produite en interne, en général avec ce qu'on appelle un multiplicateur de tension ou "pompe de charge", n'est pas accompagnée d'une puissance suffisante. Autrement dit, la pompe de charge produit une tension suffisante mais en général pas un courant suffisant, ou en tout cas pas de manière assez durable.

Il semble en effet que l'insuffisance de courant pendant le claquage (claquage dû d'abord à la tension Vpp) aboutit à une liaison trop résistive à travers l'oxyde mince entre les deux conducteurs.

On pense qu'il est nécessaire d'assurer un courant suffisant (quelques milliampères) pendant quelques dizaines de millisecondes après le claquage en tension, pour stabiliser à une valeur suffisamment faible la résistance de la connexion établie.

L'invention propose un procédé et un schéma de circuit permettant d'améliorer la fiabilité du claquage des fusibles.

Selon l'invention, on propose un circuit intégré alimenté par une tension d'alimentation Vcc, comprenant entre autre un fusible et un circuit de claquage de ce fusible, le circuit de claquage utilisant une tension de claquage Vpp largement supérieure à la tension d'alimentation, le circuit de claquage étant caractérisé en ce qu'il comporte des moyens pour fournir au fusible un courant durable à partir de tension d'alimentation Vcc immédiatement à la suite de l'application de la tension de claquage Vpp l'intensité du courant étant suffisante pour stabiliser la valeur de la résistance du fusible claqué.

Ainsi, notamment dans les fusibles à claquage d'isolant mince, alors que l'isolant mince vient de claquer sous l'effet du champ électrique engendré par la tension de claquage, on applique immédiatement une autre source de tension au fusible, cette source de tension ayant un potentiel beaucoup plus faible mais étant capable de fournir un courant durable (ordre de grandeur quelques dizaines de millisecondes) avec une intensité suffisante pendant ce temps (supérieure à celle que peut fournir durablement la source de tension de claquage).

Le claquage du fusible ne s'interrompt donc pas prématurément, même si la source de tension de claquage est incapable de fournir un courant suffisant à travers le fusible. La tension d'alimentation normale prend le relais pour fournir du courant, alors que le fusible est encore "chaud". C'est à ce moment que sa résistance est la plus faible et qu'elle permet effectivement de passer un courant important (ordre de grandeur : quelques milliampères).

Dans une réalisation, le fusible est relié à la source de tension de claquage Vpp par un premier transistor et à la source d'alimentation par un deuxième transistor. Ces deux transistors sont commandés, directement ou indirectement, par un signal de commande de claquage unique. Le fusible est relié de l'autre côté à la masse. Etant donné que le signal de commande de claquage est en principe un signal logique entre 0 et Vcc, on prévoit de préférence que le signal de commande est appliqué à la grille du premier transistor par l'intermédiaire d'un transistor d'isolation qui a sa grille à la tension d'alimentation normale à Vcc. Un transistor de polarisation monté en résistance est de préférence prévu alors entre Vpp et la grille du premier transistor.

Dans une autre réalisation, il y a encore un premier transistor relié entre la source de tension de claquage Vpp et le fusible, un deuxième transistor relié entre l'alimentation Vcc et la source de tension de claquage, et un troisième transistor également relié entre l'alimentation et la source de tension de claquage. Là encore le fusible peut être relié par sa deuxième extrémité d'un transistor.

Le deuxième transistor est alors de préférence commandé par le signal de commande de claquage, par l'intermédiaire d'un transistor d'isolation dont la grille est commandée par la tension de claquage; le troisième transistor est commandé directement par le signal de commande de claquage.

L'invention s'applique notamment, mais non exclusivement, aux fusibles à claquage d'isolant mince.

D'autres particularités et avantages de l'invention apparaîtront à la lecture de la description qui est faite à titre illustratif et non limitatif à partir des dessins sur lesquels :
- la figure 1 représente un exemple de fusible à claquage d'oxyde pour lequel l'invention peut tout particulièrement s'appliquer;
- la figure 2 représente un circuit de claquage conforme à l'invention;
- la figure 3 représente les diagrammes temporels des potentiels appliqués au circuit de la figure 2;
- la figure 4 représente un autre mode de réalisation de circuit de claquage selon l'invention;
- la figure 5 représente les diagrammes temporels de potentiels dans le cas du reclaquage d'un fusible déjà claqué.
- la figure 6 représente une modification du schéma de la figure 4;
- la figure 7 représente un diagramme temporel correspondant à la figure 6.

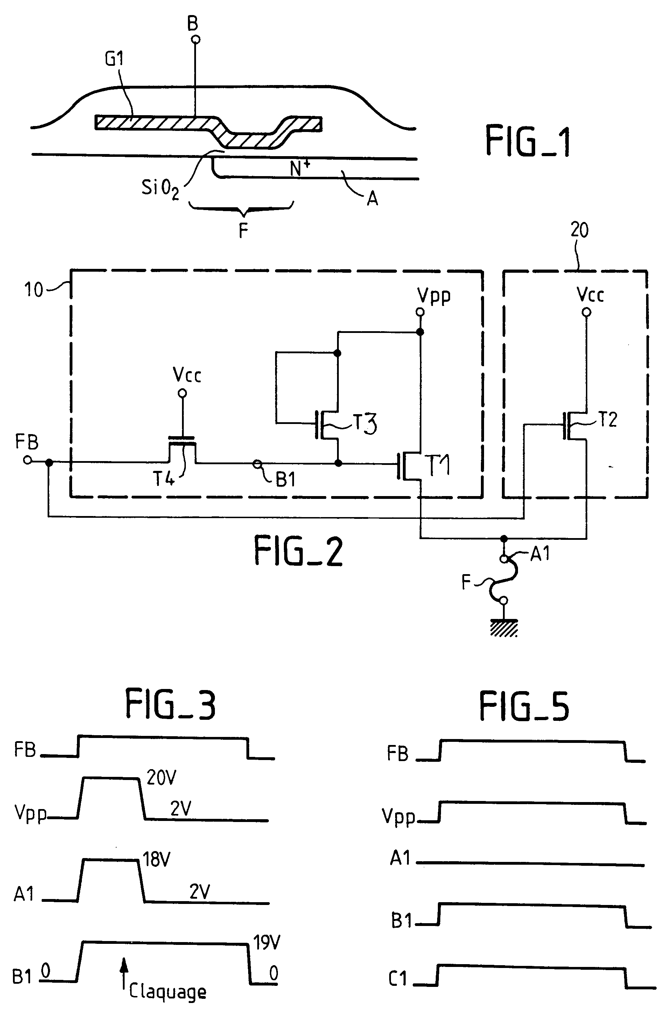

La figure 1 illustre à titre d'exemple un fusible à claquage d'oxyde du type de celui décrit plus en détail dans le brevet EP-A-0 408 419 cité précédemment, et réalisé selon la même technologie qu'une mémoire EEPROM à transistors à grille flottante. Dans l'exemple représenté, il comporte une grille de silicium polycristallin G1 qui forme un premier conducteur B; un deuxième conducteur A est formé par une diffusion N+ dans un substrat de silicium monocristallin. La grille G1, s'étend au dessus du substrat, partiellement au dessus de la diffusion N+, et en est isolée par une couche mince d'oxyde de silicium (SiO2). L'oxyde de silicium est fortement aminci localement dans une zone séparant la grille de la diffusion N+. C'est cette zone amincie qui constitue le fusible F. Dans l'état intact, l'oxyde isole les deux conducteurs pour des tensions inférieures ou égales à la tension d'alimentation normale Vcc du circuit intégré. Dans l'état claqué, l'oxyde de silicium est détérioré et devient résistif, reliant ainsi les deux conducteurs A et B. Ce fusible est en principe associé à un circuit de lecture de l'état du fusible, non représenté, qui permet de déterminer s'il y a ou non passage de courant entre les conducteurs A et B.

Le claquage se fait par application d'une tension Vpp d'une vingtaine de volts sur la diffusion N+, la grille étant à la masse, ou l'inverse.

La figure 2 représente le principe général de l'invention, en relation avec une première réalisation pratique.

Le circuit de commande de claquage comporte deux parties; la première (10) consiste en un moyen pour appliquer la tension de claquage Vpp au fusible; la deuxième (20) consiste en un moyen pour appliquer au fusible, aussitôt après le claquage, la tension d'alimentation Vcc, à travers un transistor dont la dimension est choisie en fonction du courant qu'on veut faire passer dans le fusible (un courant supérieur à celui que peut fournir durablement la source de tension de claquage).

Le fusible F est relié entre un noeud A1 et la masse. Le noeud A1 est relié à la source d'un premier transistor T1 dont le drain est relié à la source de tension de claquage Vpp; cette source est de préférence une source interne au circuit intégré, par exemple une pompe de charge ou multiplicateur de tension, non représenté.

Le noeud A1 est par ailleurs relié à la source d'un deuxième transistor T2 dont le drain est relié à la tension d'alimentation normale Vcc du circuit intégré. La grille de ce deuxième transistor est commandée par un signal de commande de claquage FB, provenant en principe d'une borne extérieure du circuit intégré, soit d'un circuit logique interne.

Pour rendre le premier transistor T1 suffisamment conducteur lorsque le signal FB est actif, on prévoit un troisième transistor T3 monté en résistance (drain relié à sa grille) et connecté entre Vpp et la grille de T1; on prévoit également un quatrième transistor T4, interposé entre l'entrée de réception du signal FB et la grille du premier transistor T1; la grille de T4 est portée à Vcc. Ce transistor isole la grille de T1 et la maintient à un potentiel élevé pendant toute l'opération de claquage.

Le transistor T1 et les transistors T3 et T4 font partie du premier moyen 10 qui applique la tension Vpp au fusible; le transistor T2 est le deuxième moyen 20, qui relie ensuite la source d'alimentation Vcc au fusible.

Le circuit fonctionne de la manière suivante (à examiner en relation avec la figure 3 qui représente les diagrammes temporels de signaux dans le circuit). Le signal de commande de claquage FB est normalement à zéro et passe à Vcc (on supposera que Vcc = 5 volts) pendant un créneau temporel de quelques dizaines de millisecondes, ce créneau représentant l'ordre de claquage du fusible F.

L'application de la tension Vpp est synchronisée avec le signal FB, c'est-à-dire que Vpp apparaît sur le drain des transistors T1 et T3 seulement sensiblement au moment du front de montée de l'ordre de claquage FB.

Initialement le transistor T4 est conducteur (source à la masse puisque FB est à zéro; grille à Vcc); La grille de T1 est donc également à la masse. Tl est bloqué.

L'ordre de claquage FB fait monter à Vcc le potentiel de source du quatrième transistor T4, bloquant ce transistor puisque sa grille est également à Vcc. La grille de T1 (noeud B1) passe à Vpp grâce au transistor T3; Vpp monte pendant ce temps à sa valeur nominale d'une vingtaine de volts. Le transistor T1, rendu conducteur, applique une surtension importante sur le noeud A1. Cette surtension est suffisante pour claquer rapidement l'isolant du fusible. Un courant circule dans le fusible, dont l'intensité dépend d'une part de la taille du transistor T3 et d'autre part de la réserve de puissance disponible dans la source de tension de claquage Vpp; si cette réserve n'est pas suffisante pour maintenir un courant de quelques milliampères pendant quelques dizaines de millisecondes, la résistance finale de la connexion établie par le fusible risque d'être trop grande (connexion insuffisamment conductrice). C'est ce qui passe en pratique lorsque la tension Vpp est fournie par une pompe de charge interne au circuit intégré, si on ne veut pas que cette pompe de charge soit exagérément encombrante.

Dans ce cas, aussitôt le fusible claqué, le potentiel Vpp s'écroule à une valeur beaucoup plus faible.

C'est alors qu'intervient le transistor T2. La grille de T2 est portée au potentiel de FB et sa source à celui du noeud A1, son drain étant à Vcc. Tant que le potentiel du noeud A1 reste proche de la valeur nominale de Vpp (entre le début du créneau Vpp et l'instant du claquage), T2 reste bloqué; mais, dès que le fusible claque, le potentiel du noeud A1 descend à une valeur beaucoup plus faible (par exemple 2 volts), de sorte que le transistor T2 devient conducteur et fournit un courant supplémentaire dans le fusible, ceci jusqu'à interruption du créneau FB, et indépendamment de la réserve de puissance disponible dans la source Vpp.

On notera que pendant que le transistor T2 conduit du courant, le transistor T1 reste conducteur car sa grille (noeud B1) reste à une tension élevée, par effet capacitif, le transistor T3 se bloquant lorsque Vpp chute vers Vcc ou au dessous et le transistor T4 étant bloqué depuis le début du créneau.

Les dimensions du transistor T2 sont choisies en fonction du courant désiré pour le claquage du fusible. On a constaté en particulier qu'il est préférable de fournir un courant supérieur à celui qui circulera en utilisation normale dans le fusible. En effet, il semble que si on grille un fusible avec un courant I, aboutissant à une certaine résistance finale R de la connexion claquée (la résistance R diminue avec le courant I), le passage ultérieur d'un courant supérieur à I risque de faire varier la valeur de la résistance de connexion, ce qui est néfaste; dans certains cas, le passage d'un courant trop supérieur au courant de claquage I peut entraîner même la destruction de la connexion, le fusible devenant à nouveau isolant, ce qui est tout-à-fait inacceptable.

Ceci pose en particulier le problème du reclaquage d'un fusible déjà claqué. Il est parfois nécessaire de redonner un ordre de claquage même si le fusible est déjà claqué.

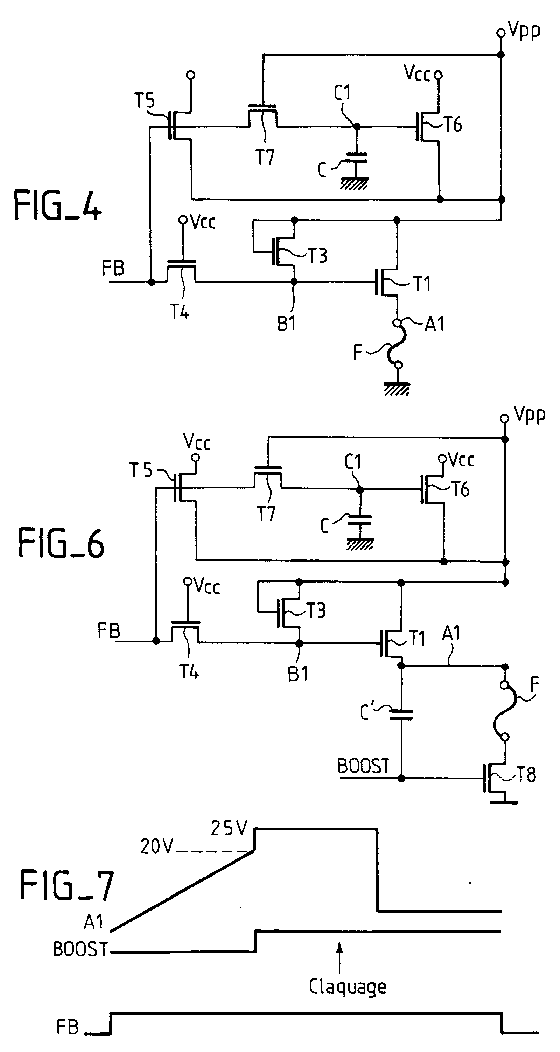

Le schéma de la figure 4 semble présenter des avantages pour permettre à la fois le claquage du fusible intact et le reclaquage d'un fusible déjà claqué, avec un courant qui est plus faible dans le deuxième cas que dans le premier cas. Ce schéma devrait donc éviter une détérioration de la connexion lors du deuxième claquage.

A la figure 4, les éléments qui correspondent à ceux de la figure 2 sont désignés par les mêmes références numériques : les transistors T1, T3, T4; le fusible F; le signal de claquage FB; les alimentations à Vcc et Vpp. Tous ces éléments sont connectés comme à la figure 2 et remplissent les mêmes fonctions.

Pour l'application de la tension d'alimentation Vcc pendant plusieurs dizaines de millisecondes, immédiatement à la suite du claquage du fusible par Vpp, on prévoit :
- un transistor T5 de petite dimension ayant sa grille commandée par le signal FB, son drain à Vcc, et sa source reliée au drain de T1 donc à la source de tension de claquage Vpp;
- un transistor T6 de grande dimension (qui fournira le courant principal après claquage du fusible par Vpp); son drain est relié à la source d'alimentation à Vcc, sa source à Vpp; sa grille est commandée par le signal FB, mais à travers un transistor d'isolation T7 dont la grille est commandée par la tension Vpp;
- une capacité C entre la grille de T6 (noeud C1) et la masse.

Lors du claquage du fusible, les potentiels varient selon sensiblement le même diagramme qu'à la figure 3; lors du reclaquage, les potentiels varient plutôt comme indiqué à la figure 5. La différence des diagrammes résulte du fait que lorsque le fusible est déjà claqué, la tension Vpp ne peut en pratique pas monter au delà de 5 volts. Il n'y a donc pas de phase où les noeuds A1 ou B1 peuvent monter à environ 20 volts. Il en résulte un courant plus faible dans le fusible. Par exemple, à aucun moment le transistor T1 n'a sa grille portée à un potentiel supérieur à 5 volts, alors qu'au moment du premier claquage le potentiel de grille de T1 est beaucoup plus élevé et laisse donc passer un courant important.

Une variante de réalisation des schémas de l'invention consiste à interposer un transistor de limitation de courant entre l'extrémité du fusible et la masse, et à commander la conduction de ce transistor par un signal (BOOST) qui débute seulement lorsque la tension de claquage Vpp a atteint ou pratiquement atteint sa valeur nominale.

Selon une autre variante, utilisable en même temps que la précédente puisqu'elle utilise un signal analogue (BOOST), on relie une capacité de bootstrap au noeud A1, c'est-à-dire à la source du transistor T1 (ou éventuellement au conducteur qui amène la tension de claquage, c'est-à-dire au drain du transistor t1). Cette capacité se charge pendant que la tension de claquage monte vers sa valeur nominale. Le signal BOOST est un créneau de tension qui passe de 0 à Vcc seulement lorsque Vpp a atteint ou pratiquement atteint sa valeur nominale.

La figure 6 représente le schéma de circuit qui résulte de ces deux modifications, apportées simultanément au schéma de la figure 4. Le transistor supplémentaire interposé entre le fusible et la masse est T8. Sa grille est commandée par le signal BOOST. La capacité de bootstrap est C'; elle est reliée au noeud A1 dans le cas de la figure 6. Son autre extrémité reçoit le signal BOOST et peut donc être reliée à la grille de T8.

La figure 7 représente les diagrammes temporels résultant de la présence du signal BOOST. La montée de tension Vpp est relativement lente; par conséquent le noeud A1 passe également lentement de 0 à sa valeur nominale (20 volts par exemple) à partir du déclenchement de l'ordre de claquage. Pendant ce temps la capacité C' se charge. Lorsque Vpp a sensiblement atteint sa valeur nominale, le signal boost est appliqué et fait monter instantanément le potentiel du noeud A1; c'est-à-dire de la première extrémité du fusible. Simultanément, le transistor T8 devient conducteur et porte l'autre extrémité du fusible à la masse. Le potentiel de claquage appliqué au fusible est donc supérieur à ce qu'il est dans le cas de figures 2 et 4, ce qui améliore la qualité finale du fusible claqué. Le transistor T8 limite le courant passant par le fusible. Ceci est utile pour contrôler le temps de décharge du noeud A1 au moment du claquage. En effet, si ce noeud se déchargeait trop vite, les transistor T1 et T6 n'ont pas assez de temps pour conduire et le fusible risque de se refroidir avant l'arrivée du courant de stabilisation provenant de la source de tension à Vcc.

## Revendications

1. Circuit intégré alimenté par une tension d'alimentation Vcc, comprenant entre autre un fusible (F) et un circuit de claquage de ce fusible, le circuit de claquage utilisant une tension de claquage Vpp largement supérieure à la tension d'alimentation Vcc, le circuit de claquage étant caractérisé en ce qu'il comporte des moyens pour fournir au fusible un courant durable à partir de la tension d'alimentation Vcc immédiatement à la suite de l'application de la tension de claquage Vpp l'intensité du courant étant suffisante pour stabiliser la valeur de la résistance du fusible claqué.

2. Circuit intégré selon la revendication 1, caractérisé en ce que la source de tension Vpp est une source interne au circuit intégré produisant une tension Vpp à partir de la tension d'alimentation Vcc.

3. Circuit intégré selon l'une des revendications 1 et 2, caractérisé en ce qu'il comporte un premier transistor (T1) relié entre la source de tension de claquage (Vpp) et le fusible, et un deuxième transistor (T2) relié entre la source de tension d'alimentation (Vcc) et le fusible.

4. Circuit intégré selon la revendication 3, caractérisé en ce que la grille du premier transistor est commandée, à travers un transistor d'isolation (T4), par un signal de commande de claquage (FB), la grille du deuxième transistor étant commandée par le signal de commande de claquage.

5. Circuit intégré selon la revendication 4, caractérisé en ce que le transistor d'isolation (T4) a une grille commandée par la tension d'alimentation (Vcc).

6. Circuit intégré selon la revendication 4, caractérisé en ce que le drain du premier transistor (T1) est relié à sa grille par un transistor de polarisation monté en résistance.

7. Circuit intégré selon l'une des revendications 1 et 2, caractérisé en ce qu'il comporte un premier transistor (T1) relié entre la source de tension de claquage (Vpp) et le fusible, un deuxième transistor (T6) relié entre la source de tension d'alimentation (Vcc) et la source de tension de claquage (Vpp), et un troisième transistor (T5) également relié entre la source de tension d'alimentation et la source de tension de claquage, le deuxième transistor étant commandé par le signal de commande de claquage à travers un transistor d'isolation (T7) dont la grille est commandée par la tension de claquage, et le troisième transistor étant commandé directement par le signal de commande de claquage.

8. Circuit intégré selon l'une des revendications précédentes, caractérisé en ce que le fusible est un fusible comprenant deux conducteurs séparés par un isolant très mince susceptible de claquer sous l'effet du champ électrique engendré dans l'isolant par l'application de la tension de claquage (Vpp) entre les conducteurs.

9. Circuit intégré selon l'une des revendications précédentes, caractérisé en ce qu'il comporte un transistor de limitation de courant (T8) interposé entre une extrémité du fusible et une masse.

10. Circuit intégré selon l'une des revendications précédentes, caractérisé en ce qu'il comporte une capacité de bootstrap (C') ayant une extrémité connectée au fusible et susceptible de se charger à la tension de claquage Vpp pendant l'application de cette tension au fusible, et une autre extrémité recevant un signal (BOOST) constitué par un créneau de tension débutant lorsque la tension Vpp a atteint sensiblement sa valeur nominale.

11. Procédé de claquage de fusible (F) dans un circuit intégré, caractérisé en ce que, immédiatement après avoir relié le fusible à une source de tension de claquage (Vpp) plus élevée que la tension d'alimentation normale (Vcc) du circuit intégré, on relie le fusible à une source d'alimentation en tension ayant un potentiel beaucoup plus faible mais étant capable de fournir un courant durable avec une intensité supérieure à celle que peut fournir durablement la source de tension de claquage.

12. Procédé selon la revendication 11, caractérisé en ce que la source de tension d'alimentation fournit un courant de quelques milliampères pendant quelques dizaines de millisecondes.

13. Procédé selon l'une des revendications 11 et 10, caractérisé en ce qu'il consiste à claquer un fusible constitué par une couche d'isolant très mince entre deux conducteurs, pour transformer cette couche isolante en couche résistive.

## Patentansprüche

1. Integrierter Schaltkreis, gespeist durch eine Vcc-Versorgungsspannung, unter anderem eine Sicherung (F) und eine Schaltung zum Durchbrennen dieser Sicherung umfassend, wobei diese Durchbrennschaltung eine Durchbrennspannung Vpp benutzt, die sehr viel größer ist als die Versorgungsspannung Vcc und diese Durchbrennschaltung **dadurch gekennzeichnet** ist, daß sie Einrichtungen enthält um, ausgehend von der Versorgungsspannung Vcc, unmittelbar nach dem Anlegen der Durchbrennspannung Vpp einen Dauerstrom-an die Sicherung zu liefern, wobei die Intensität des Stroms ausreichend groß ist, um den Widerstandswert der durchgebrannten Sicherung zu stabilisieren.

2. Schaltkreis nach Anspruch 1, dadurch gekennzeichnet, daß die Vpp-Spannungsquelle eine interne Quelle des integrierten Schaltkreises ist, die aus der Versorgungsspannung Vcc eine Spannung Vpp herstellt.

3. Schaltkreis nach einem der Ansprüche 1 und 2, dadurch gekennzeichnet, daß er einen ersten Transistor (T1) umfaßt, eingeschaltet zwischen die Durchbrennspannungsquelle (Vpp) und die Sicherung, und einen zweiten Transistor (T2), eingeschaltet zwischen die Versorgungsspannungsquelle (Vcc) und die Sicherung.

4. Schaltkreis nach Anspruch 3, dadurch gekennzeichnet, daß das Gate des ersten Transistors über einen Isolationstransistor (T4) gesteuert wird durch ein Durchbrenn-Steuersignal (FB), das Gate des zweiten Transistors gesteuert wird durch das Durchbrenn-Steuersignal.

5. Schaltkreis nach Anspruch 4, dadurch gekennzeichnet, daß der Isolationstransitor (T4) ein durch die Versorgungsspannung (Vcc) gesteuertes Gate hat.

6. Schaltkreis nach Anspruch 4, dadurch gekennzeichnet, daß der Drain des ersten Transistors (T1) mit seinem Gate verbunden ist mit einem als Widerstand geschalteten Vorspannungs- bzw. Polarisationstransistor.

7. Schaltkreis nach einem der Ansprüche 1 und 2, dadurch gekennzeichnet, daß er einen ersten Transistor (T1), eingeschaltet zwischen die Durchbrennspannungsquelle (Vpp) und die Sicherung, einen zweiten Transistor (T6), eingeschaltet zwischen die Versorgungsspannungsquelle (Vcc) und die Durchbrennspannungsquelle (Vpp), und einen dritten Transistor (T5) umfaßt, ebenfalls eingeschaltet zwischen die Versorgungsspannungsquelle und die Durchbrennspannungquelle, wobei der zweite Transistor durch das Durchbrenn-Steuersignal gesteuert wird über einen Isolationstransistor (T7), dessen Gate durch die Durchbrennspannung gesteuert wird, und der dritte Transistor direkt durch das Durchbrenn-Steuersignal gesteuert wird.

8. Schaltkreis nach einem der vorhergehenden Ansprüche, dadurch gekennzeichnet, daß die Sicherung eine Sicherung ist, die zwei Leiter umfaßt, getrennt durch einen sehr dünnen Isolator, geeignet, durchzubrennen unter der Wirkung des elektrischen Feldes, das in dem elektrischen Isolator erzeugt wird durch die Anwendung der Durchbrennspannung (Vpp) zwischen den Leitern.

9. Schaltkreis nach einem der vorhergehenden Ansprüche, dadurch gekennzeichnet, daß er einen Strombegrenzungstransistor (T8) umfaßt, eingeschaltet zwischen einem Ende der Sicherung und einer Masse.

10. Schaltkreis nach einem der vorhergehenden Ansprüche, dadurch gekennzeichnet, daß er eine Bootstrap-Kapazität (C') umfaßt, mit einem Ende mit der Sicherung verbunden und imstande, sich mit der Durchbrennspannung Vpp aufzuladen während des Anlegens dieser Spannung an die Sicherung, wobei ein anderes Ende ein Signal (BOOST) empfängt, gebildet durch einen Spannungsimpuls, der beginnt, wenn die Spannung Vpp im wesentlichen ihren Nennwert erreicht hat.

11. Verfahren zum Durchbrennen der Sicherung (F) in einem integrierten Schaltkreis, dadurch gekennzeichnet, daß, unmittelbar nach dem Verbinden der Sicherung mit einer Druchbrennspannungsquelle (Vpp) höherer Spannung als die normale Versorgungsspannung (Vcc) der intgegrierten Schaltung, man die Sicherung mit einer Versorgungsspannungsquelle verbindet, die ein sehr viel kleineres Potential aufweist, aber imstande ist, einen Dauerstrom mit einer Stärke zu liefern, die höher ist als die, welche die Durchbrennspannungquelle dauerhaft liefern kann.

12. Verfahren nach Anspruch 11, dadurch gekennzeichnet, daß die Versorgungsspannungsquelle während ungefähr zehn Millisekunden einen Strom von einigen Milliampère liefert.

13. Verfahren nach einem der Ansprüche 11 und 10, dadurch gekennzeichnet, daß es darin besteht, eine Sicherung durchzubrennen, die gebildet wird durch eine sehr dünne Isolatorschicht zwischen zwei Leitern, um diese isolierende Schicht umzuwandeln in eine resistive Schicht.

## Claims

1. Integrated circuit fed with a supply voltage V_{cc}, comprising inter alia a fuse (F) and a circuit for blowing this fuse, the fuse blowing circuit using a fuse blowing voltage Vpp considerably above the feed voltage V_{cc}, the fuse blowing circuit being characterized by the fact that it comprises means for supplying the fuse with a durable current from the supply voltage V_{cc} immediately following the application of the fuse blowing voltage Vpp, the current intensity being sufficient to stabilize the value of the resistance of the blown fuse.

2. Integrated circuit in accordance with Claim 1, characterized by the fact that the voltage source Vpp is an internal source of the integrated circuit, producing a voltage Vpp from the supply voltage V_{cc}.

3. Integrated circuit in accordance with either of Claims 1 and 2, characterized by the fact that it comprises a first transistor (T1),connected between the source of the fuse blowing voltage (Vpp) and the fuse, and a second transistor (T2), connected between the voltage source (V_{cc}) and the fuse.

4. Integrated circuit in accordance with Claim 3, characterized by the fact that the grid of the first transistor is controlled, via an insulation transistor (T4) by a fuse blowing control signal (FB), the grid of the second transistor being controlled by the fuse blowing control signal.

5. Integrated circuit in accordance with Claim 4, characterized by the fact that the insulation transistor (T4) has a grid controlled by the supply voltage (V_{cc}).

6. Integrated circuit in accordance with Claim 4, characterized by the fact that the drain of the first transistor (T1) is connected to its grid by a polarization transistor mounted as a resistance.

7. Integrated circuit in accordance with either one of Claims 1 and 2, characterized by the fact that it comprises a first transistor (T1) connected between the source of fuse blowing voltage (Vpp) and the fuse, a second transistor (T6) connected between the source of supply voltage (V_{cc}) and the source of fuse blowing voltage (Vpp) and a third transistor (T5) connected between the source of supply voltage and the source of fuse blowing voltage, the second transistor being controlled by the fuse blowing control signal via an insulation transistor (T7) of which the grid is controlled by the fuse blowing voltage and the third transistor being controlled direct by the fuse blowing control signal.

8. Integrated circuit in accordance with any one of the preceding claims, characterized by the fact that the fuse is a fuse comprising two conductors separated by a very thin insulant capable of blowing under the effect of the magnetic field generated in the insulant by the application of the fuse blowing voltage (Vpp) between the conductors.

9. Integrated circuit in accordance with any one of the preceding claims, characterized by the fact that it comprises a current limitina transistor (T8) interposed between an end of the fuse and a mass.

10. Integrated circuit in accordance with any one of the preceding claims, characterized by the fact that it comprises a bootstrap capacitor (C') having one end connected to the fuse and capable of charging itself to the fuse blowing voltage Vpp during the application of this voltage to the fuse and another end receiving a signal (BOOST) formed by a voltage jump commencing when the voltage Vpp has reached approximately its nominal value.

11. Fuse blowing process (F) in an integrated circuit, characterized by the fact that immediately after the fuse has been connected to a fuse blowing voltage source (Vpp) higher than the normal supply voltage (Vcc) of the integrated circuit the fuse is connected to a supply voltage source having a much lower potential but capable of supplying a durable current of an intensity above that obtainable durably from the fuse blowing voltage source.

12. Process in accordance with Claim 11, characterized by the fact that the supply voltage source supplies a current of a few milliampers for a few tenths of a millisecond.

13. Process according to either of Claims 11 and 10, characterized by the fact that it consists of blowing a fuse formed by a very thin layer of insulant between two conductors, in order to convert this insulating layer into a resistant layer.
